# EUROPEAN PATENT APPLICATION

(11) **EP 4 835 609 A1**
(43) Date of publication of application: **04.11.2026**
(21) Application number: 26165012.1
(22) Date of filing: 16.03.2026
(51) Int. Cl.: G06F 1/186, H05K 7/14

(54) **REMOTE RELEASE MODULE AND CIRCUIT BOARD DEVICE**

(30) Priority: 28.04.2025 TW 114115858
(71) Applicant: Giga-Byte Technology Co., Ltd., New Taipei City 231 (TW)
(72) Inventor: LAI, Chih-Ming, 231 New Taipei City (TW); WU, Wen Chen, 231 New Taipei City (TW); CHOU, Hui-Shan, 231 New Taipei City (TW)
(74) Representative: Becker, Eberhard

(57) **Abstract**

A remote release module (100) includes buttons (110), moving members (120), rotating shafts (130), and hooks (136). The moving members (120) partially overlap each other and move independently of each other. The moving members (120) respectively link the buttons (110) and respectively include first driving portions (125). The rotating shafts (130) rotate independently of each other, and respectively include second driving portions (132) and third driving portions (134) protruding from the circumferential side. Each of the second driving portions (132) is linked to the corresponding first driving portion (125). The hooks (136) are respectively disposed beside the third driving portions (134). When any one of the buttons (110) is pressed, the corresponding moving member (120) is driven, and the first driving portion (125) drives the second driving portion (132), so that the corresponding rotating shaft (130) rotates, and then the third driving portion (134) drives the corresponding hook (136) to disengage.

## Description

### BACKGROUND

### Technical Field

The disclosure relates to a remote release module and a circuit board device, and more particularly, to a remote release module and a circuit board device having multiple hooks that may be independently operated.

### Description of Related Art

Currently, when an expansion card is inserted into a slot on a motherboard, the expansion card may be released by pressing a release device beside the slot. With the advancement of technology, AI and high-end audio-visual products have the demand for using multiple expansion cards simultaneously. How to disengage a single expansion card without affecting other expansion cards is also a direction to be researched in the art.

### SUMMARY

The disclosure provides a remote release module having multiple buttons located at a remote end and independently operated.

The disclosure provides a circuit board device having the above remote release module.

A remote release module in the disclosure includes multiple buttons, multiple moving members, multiple rotating shafts, and multiple hooks. The moving members partially overlap each other and move independently of each other. The moving members respectively link the buttons, and respectively include multiple first driving portions. The rotating shafts rotate independently of each other, and respectively include multiple second driving portions and multiple third driving portions protruding from a circumferential side. Each of the rotating shafts include the corresponding second driving portion and the corresponding third driving portion, and each of the second driving portions is linked to the corresponding first driving portion. The hooks are respectively disposed beside the third driving portions. When any one of the buttons is pressed, the corresponding moving member is driven, and the first driving portion drives the second driving portion, so that the corresponding rotating shaft rotates, and then the third driving portion drives the corresponding hook to disengage.

In an embodiment of the disclosure, the moving members respectively include multiple first segment portions, multiple second segment portions, multiple third segment portions, and multiple fourth segment portions connected in sequence and in a bent manner. The buttons respectively push the first segment portions. The first driving portions are respectively located at the fourth segment portions. The second segment portions overlap each other. The third segment portions overlap each other.

In an embodiment of the disclosure, the second driving portions have different protrusion lengths, and the first driving portions respectively have different distances from the rotating shafts.

In an embodiment of the disclosure, the rotating shafts have different lengths, and the protrusion length of the second driving portion of one of the rotating shafts having a greater length is greater than the protrusion length of the second driving portion of one of the rotating shafts having a smaller length.

In an embodiment of the disclosure, among two adjacently overlapping ones of the moving members, one of the moving members includes multiple protruding portions protruding toward the other moving member.

In an embodiment of the disclosure, the remote release module further includes a button base. The buttons are movably disposed on the button base. The buttons are located at a same side of the moving members. The button base covers a portion of each of the moving members. The button base includes a guide post. The moving members respectively include multiple guide slots corresponding to each other. The guide post penetrates through the guide slots.

In an embodiment of the disclosure, the rotating shafts extend along a same axis.

In an embodiment of the disclosure, the remote release module further includes a hook base. The rotating shafts are pivotally disposed on the hook base. The hooks are retractably disposed on the hook base. The hook base includes a recessed portion located between the hooks. The first driving portions and the second driving portions are located at a same side of the recessed portion.

A circuit board device in the disclosure includes a circuit board body, the above remote release module, and a heat sink. The circuit board body includes multiple PCI-E connectors. The hooks correspond to the PCI-E connectors. The remote release module further includes a hook base. The rotating shafts are pivotally disposed on the hook base. The hooks are retractably disposed on the hook base. The hook base includes a recessed portion located between the hooks. The heat sink spans across the hook base and extends between the PCI-E connectors. The partial heat sink is located above the recessed portion.

In an embodiment of the disclosure, the first driving portions and the second driving portions are located on a same side of the recessed portion, and a top surface of the heat sink is flush with a top surface of the hook base.

Based on the above, in the remote release module of the disclosure, the moving members linked to the buttons move independently of each other, and the rotating shafts rotate independently of each other. The first driving portion of the moving member links the second driving portion of the corresponding rotating shaft. The hook is disposed beside the corresponding third driving portion. When any one of the buttons is pressed, the corresponding moving member is driven, and the first driving portion drives the second driving portion, so that the corresponding rotating shaft rotates, and then the third driving portion drives the corresponding hook to disengage. Since the linkage state of each group of the buttons, the moving members, the rotating shafts, and the hooks is independent, the user may operate as needed to enable the hook to disengage, thereby releasing the expansion card assembly at the specific position. In addition, the moving members partially overlap each other, thereby reducing an area occupied by the circuit board body.

### BRIEF DESCRIPTION OF THE DRAWINGS

FIG. 1 is a schematic top view of a circuit board device according to an embodiment of the disclosure.
FIG. 2 is a schematic top view of FIG. 1 with an expansion card assembly removed.
FIG. 3 is a schematic three-dimensional view of FIG. 2.
FIG. 4 is a schematic three-dimensional view of an external appearance of a remote release module of FIG. 1.
FIG. 5 and FIG. 6 are schematic perspective views of FIG. 4 from another viewing angle.
FIG. 7 and FIG. 8 are schematic exploded views of FIG. 4 from different viewing angles.
FIG. 9 and FIG. 10 are schematic partial cross-sectional views of FIG. 4 before and after a hook moves.
FIG. 11 is a schematic cross-sectional view of a button and a moving member of FIG. 4.
FIG. 12 is a schematic view of the button, a second elastic member, and the partial moving member of FIG. 4.

### DETAILED DESCRIPTION OF DISCLOSED EMBODIMENTS

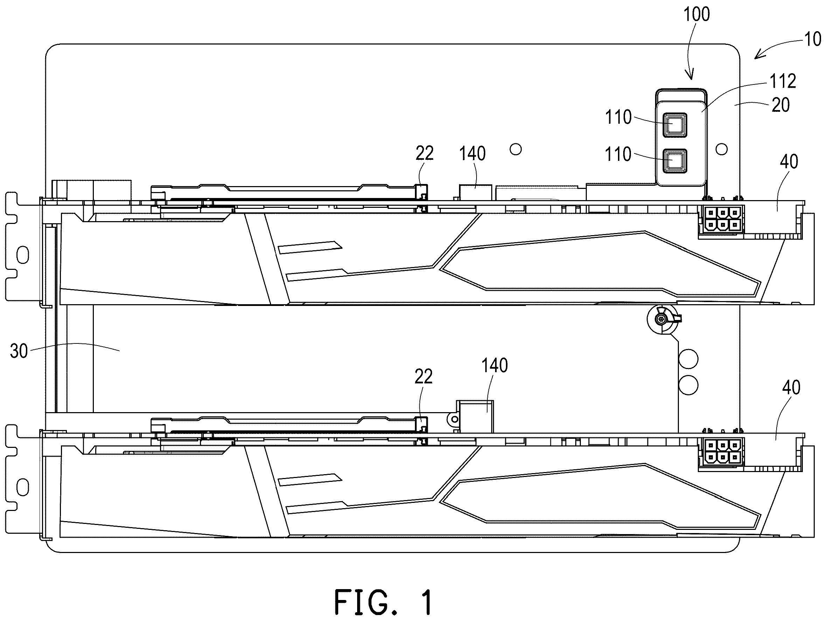

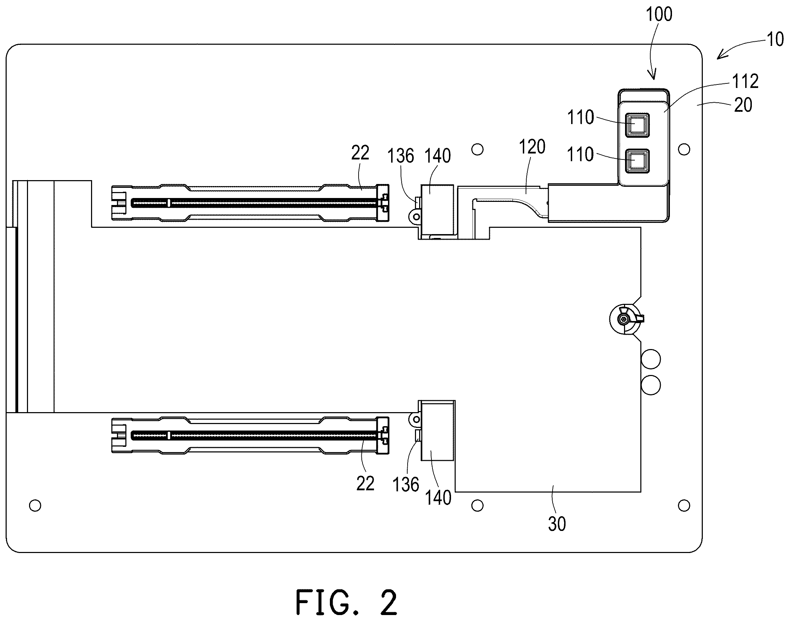

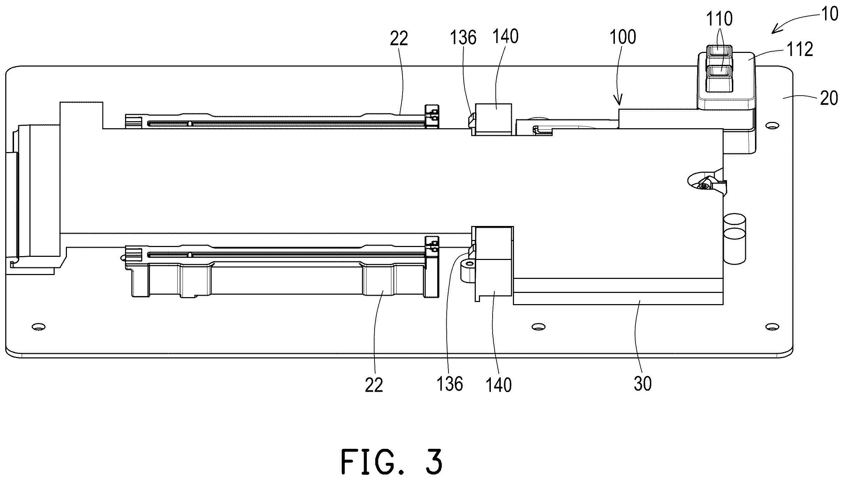

FIG. 1 is a schematic top view of a circuit board device according to an embodiment of the disclosure. FIG. 2 is a schematic top view of FIG. 1 with an expansion card assembly removed. FIG. 3 is a schematic three-dimensional view of FIG. 2.

Referring to FIG. 1 to FIG. 3, a circuit board device 10 in this embodiment includes a circuit board body 20, a remote release module 100, and a heat sink 30. The circuit board body 20 is, for example, a motherboard, but in other embodiments, the circuit board body 20 may also be an expansion circuit board. The circuit board body 20 includes multiple PCI-E connectors 22. Multiple expansion card assemblies 40 are detachably disposed on the PCI-E connectors 22. The number of PCI-E connectors 22 is two as an example, but is not limited thereto. The remote release module 100 is located at one side of the PCI-E connectors 22, and is used to secure or release the expansion card assemblies 40 inserted on the PCI-E connectors 22.

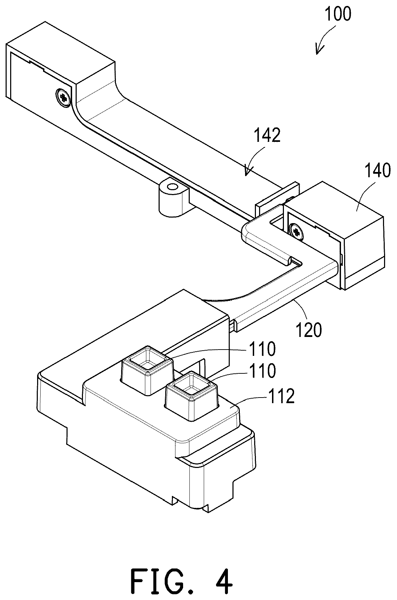

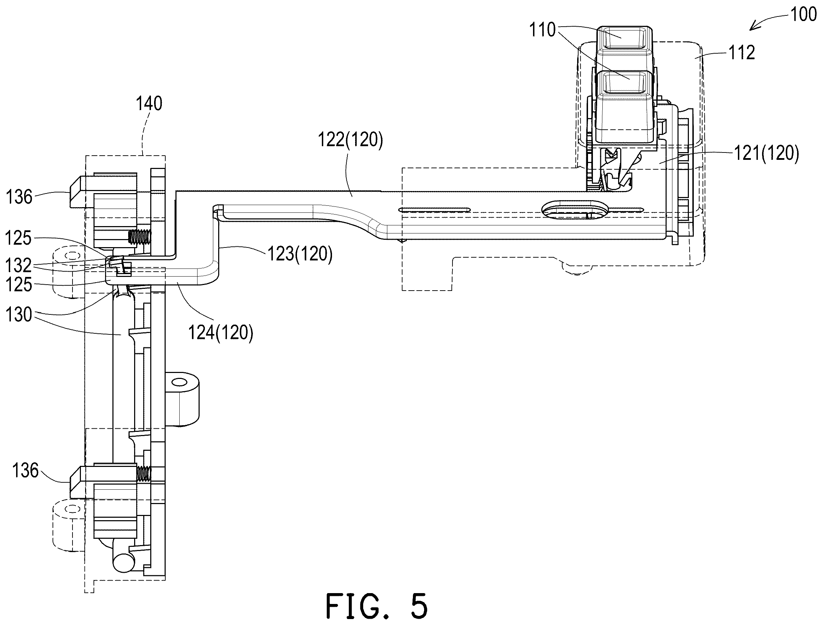

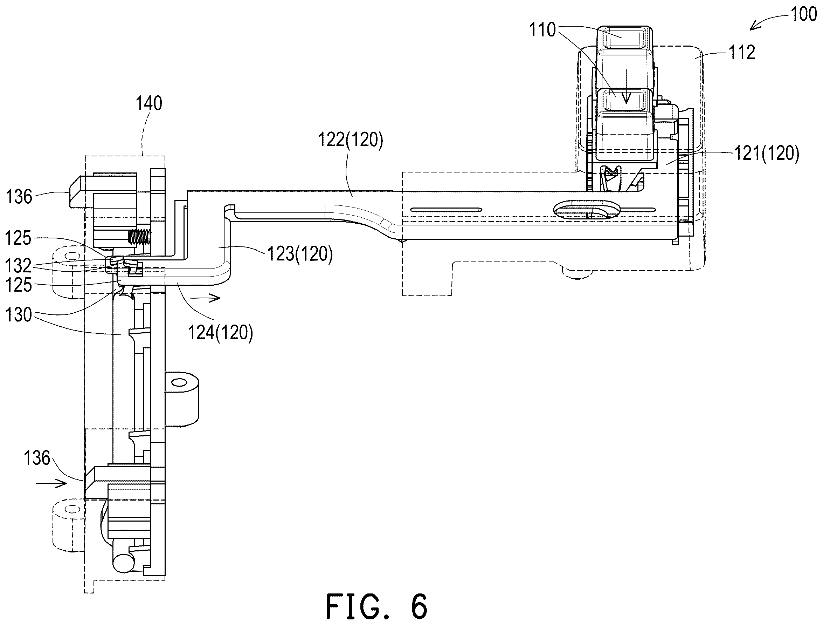

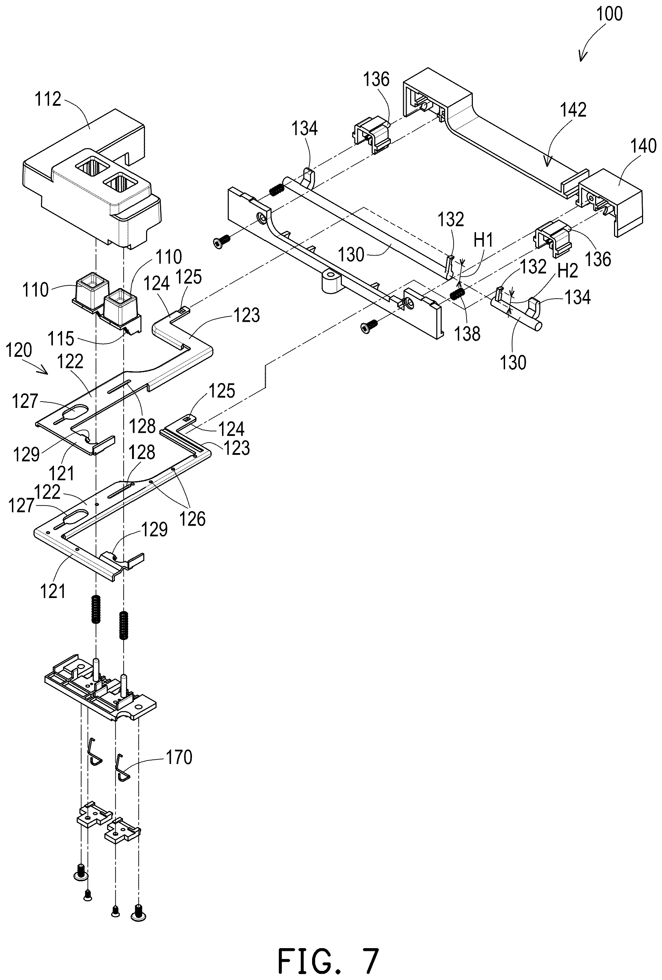

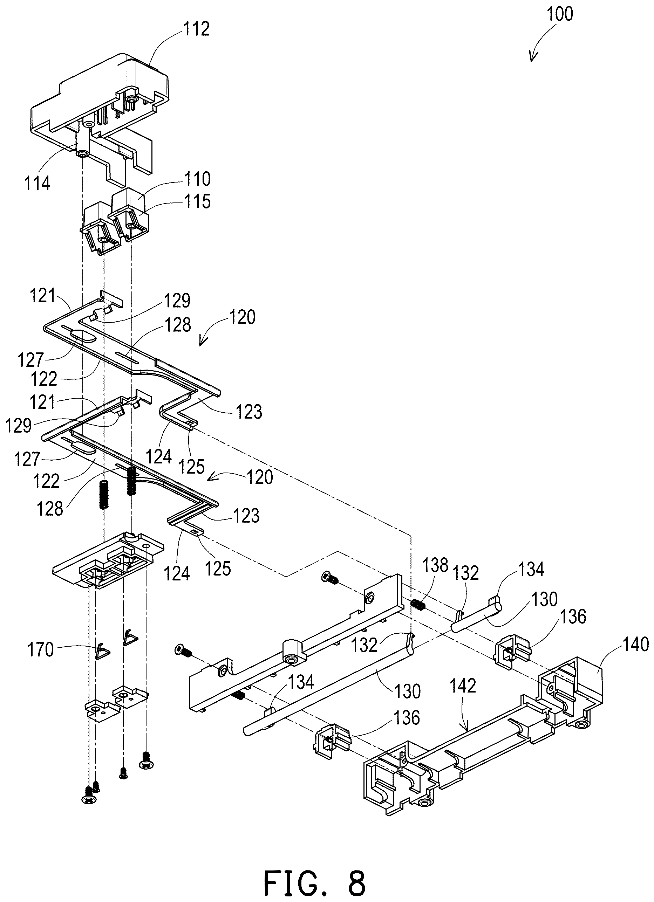

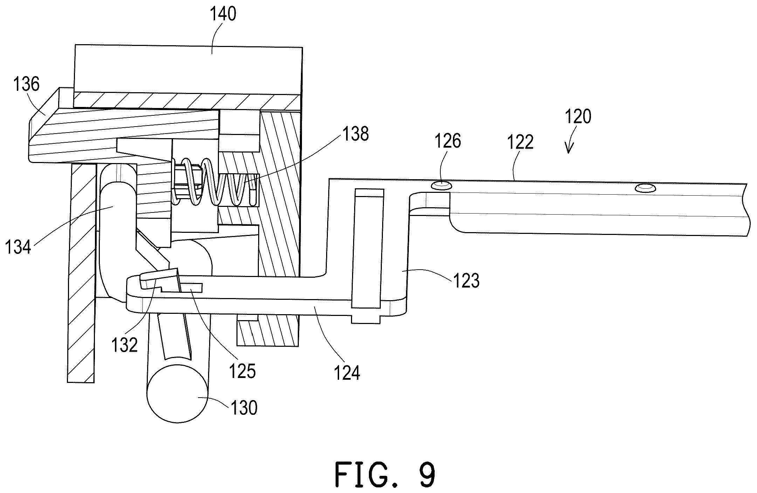

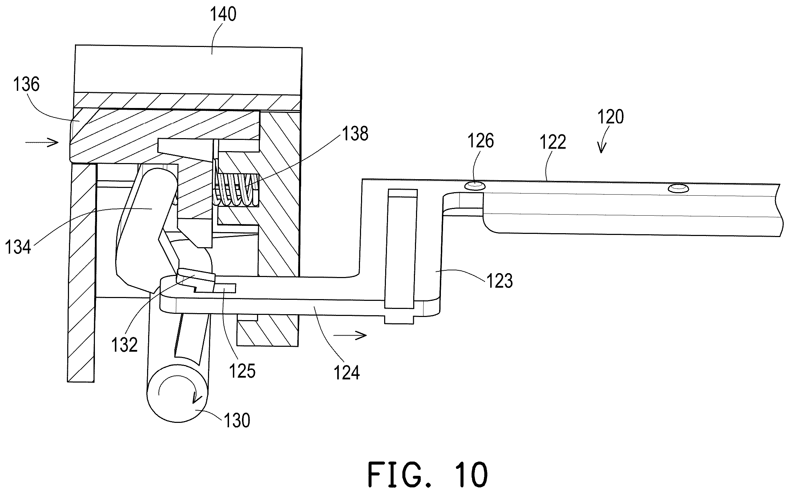

The remote release module 100 will be described in detail below. FIG. 4 is a schematic three-dimensional view of an external appearance of a remote release module of FIG. 1. FIG. 5 and FIG. 6 are schematic perspective views of FIG. 4 from another viewing angle. FIG. 7 and FIG. 8 are schematic exploded views of FIG. 4 from different viewing angles. FIG. 9 and FIG. 10 are schematic partial cross-sectional views of FIG. 4 before and after a hook moves.

Referring to FIG. 4 to FIG. 10, the remote release module 100 in this embodiment includes multiple buttons 110, multiple moving members 120, multiple rotating shafts 130, and multiple hooks 136. In this embodiment, the number of buttons 110, moving members 120, rotating shafts 130, and hooks 136 is two each as an example, but is not limited thereto. It is only required to correspond to the PCI-E connectors 22. In other embodiments, the number of buttons 110, moving members 120, rotating shafts 130, and hooks 136 may also be three or more.

In this embodiment, the remote release module 100 further includes a button base 112. The buttons 110 are movably disposed on the button base 112. The button base 112 covers a portion of each of the moving members 120, and is fixed on the circuit board body 20 (FIG. 1).

Compared to the conventional button being close to the corresponding PCI-E connector, in this embodiment, the buttons 110 are located at the same side of the moving members 120. In this embodiment, the buttons 110 are away from the PCI-E connectors 22. Such a design may enable the buttons 110 to be located outside a region where the PCI-E connectors 22 are located, and not easily blocked by the expansion card assemblies 40 inserted on the PCI-E connectors 22.

The moving members 120 respectively link the buttons 110, and respectively include multiple first driving portions 125. Specifically, in this embodiment, each of the moving members 120 includes a first segment portion 121, a second segment portion 122, a third segment portion 123, and a fourth segment portion 124 that are connected in sequence and in a bent manner, and each of the buttons 110 pushes the first segment portion 121 of the corresponding moving member 120. The first driving portion 125 is located at the fourth segment portion 124.

In addition, the moving members 120 partially overlap each other, and move independently of each other. Such a design may reduce an area of the circuit board body 20 occupied by the moving members 120, so as to free up more space for other elements to be disposed on the circuit board body 20, thereby increasing flexibility in layout of elements or/and circuits of the circuit board body 20. In this embodiment, the second segment portions 122 of the moving members 120 overlap each other, and the third segment portions 123 overlap each other. Of course, a shape and an overlapping region of the moving members 120 are not limited thereto.

As may be seen from FIG. 7, among two adjacently overlapping ones of the moving members 120, one of the moving members 120 includes multiple protruding portions 126 protruding toward the other moving member 120. In this embodiment, the moving member 120 located below includes the protruding portions 126 protruding toward the moving member 120 located above. Of course, in other embodiments, the moving member 120 located above may also include the protruding portions 126 protruding toward the moving member 120 located below. Such a design may effectively reduce a contact area between the two moving members 120 overlapping above and below, so as to reduce friction and avoid one of the moving members 120 driving the other moving member 120 during a moving process to ensure that the moving members 120 may be independently operated.

In addition, as shown in FIG. 8, the button base 112 includes a guide post 114. The moving members 120 respectively include multiple guide slots 127 corresponding to each other, and the guide post 114 penetrates through the guide slots 127. Such a design may ensure that the moving members 120 may move along a specific direction, while maintaining a state of overlapping each other. In this embodiment, each of the moving members 120 further includes a trench 128, and the circuit board body 20 may have a corresponding protruding structure (not shown) penetrating through the trench 128, so as to further enable the moving members 120 to move along the specific direction without shaking.

As shown in FIG. 7 and FIG. 8, the rotating shafts 130 rotate independently of each other, and extend along the same axis. The rotating shafts 130 respectively include multiple second driving portions 132 and multiple third driving portions 134 protruding from a circumferential side. That is to say, each of the rotating shafts 130 includes the corresponding second driving portion 132 and third driving portion 134. In this embodiment, each of the second driving portions 132 is linked to the corresponding first driving portion 125.

Specifically, the first driving portion 125 is, for example, a hole, and the second driving portion 132 is, for example, a hook portion penetrating through the hole. Of course, forms of the first driving portion 125 and the second driving portion 132 are not limited thereto.

As shown in FIG. 7, in this embodiment, the second driving portions 132 have different protrusion lengths H1 and H2, and the first driving portions 125 respectively have different distances from the rotating shafts 130. Specifically, the rotating shafts 130 have different lengths. The protrusion length H1 of the second driving portion 132 of one of the rotating shafts 130 having a greater length is greater than the protrusion length H2 of the second driving portion 132 of one of the rotating shafts 130 having a smaller length.

In addition, since the two moving members 120 partially overlap, a distance (that is, a moment arm) between the first driving portion 125 of the moving member 120 located above and the rotating shaft 130 corresponding to the driven second driving portion 132 is greater than a distance (that is, a moment arm) between the first driving portion 125 of the moving member 120 located below and the rotating shaft 130 corresponding to the driven second driving portion 132.

Such a design may enable the second driving portion 132 driven by the first driving portion 125 of the moving member 120 located above to receive a relatively large torque. In this embodiment, because the second driving portion 132 and the third driving portion 134 of the longer rotating shaft 130 are respectively located at two ends that are relatively far apart, in order to avoid that when a length of the rotating shaft 130 is greater, a rotation angle of an end of the rotating shaft 130 is smaller, the rotation angles of the two ends of the rotating shaft 130 are inconsistent. In this embodiment, the above structural design may enable the rotating shaft 130 having a greater length to obtain a larger torque at the second driving portion 132 to drive the rotating shaft 130 to rotate, thereby causing the third driving portion 134 to rotate at a sufficient angle, and then enabling the hook 136 to retract a sufficient distance.

As shown in FIG. 5 and FIG. 6, the hooks 136 are respectively disposed beside the third driving portions 134 (FIG. 7). The remote release module 100 further includes a hook base 140, and the rotating shafts 130 are pivotally disposed on the hook base 140. The hooks 136 are retractably disposed on the hook base 140. The hooks 136 correspond to the PCI-E connectors 22 (FIG. 2), and each of the hooks 136 may be used to secure and release the expansion card assembly 40 disposed on the PCI-E connector 22.

In FIG. 9 and FIG. 10, the moving member 120 located below and the corresponding rotating shaft 130 and hook 136 are taken as an example. When the button 110 (FIG. 1) is pressed, the corresponding moving member 120 is driven, and the first driving portion 125 of the moving member 120 drives the second driving portion 132 of the rotating shaft 130, so that the corresponding rotating shaft 130 rotates, and then the third driving portion 134 of the rotating shaft 130 drives the corresponding hook 136 to disengage.

In this embodiment, a first elastic member 138 is disposed between the hook 136 and the hook base 140. When the hook 136 disengages, the first elastic member 138 is compressed and accumulates elastic force. When a position restriction of the hook 136 is released, the first elastic member 138 pushes the hook 136 back in place.

In the remote release module 100 in this embodiment, since a linkage state of each group of the buttons 110, the moving members 120, the rotating shafts 130, and the hooks 136 is independent, a user may operate as needed to enable the corresponding hook 136 to disengage, thereby releasing the expansion card assembly 40 at a specific position, which is quite convenient in use.

Referring back to FIG. 3, in this embodiment, in order to provide a better heat dissipation effect, the heat sink 30 extends and spans across the remote release module 100 to provide large-area heat dissipation. The hook base 140 includes a recessed portion 142 (FIG. 4) located between the hooks 136. The heat sink 30 spans across the hook base 140 and extends between the PCI-E connectors 22, and the partial heat sink 30 is located above the recessed portion 142.

The first driving portions 125 and the second driving portions 132 are located on the same side of the recessed portion 142, thereby leaving more space for the heat sink 30 to span across. In addition, in this embodiment, a top surface of the heat sink 30 is flush with a top surface of the hook base 140, so as to avoid affecting insertion of the expansion card assembly 40.

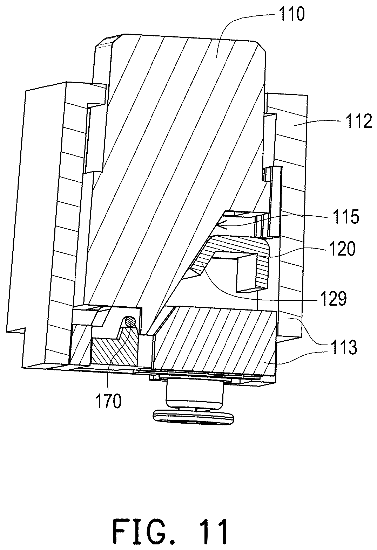

FIG. 11 is a schematic cross-sectional view of a button and a moving member of FIG. 4. Referring to FIG. 11, in this embodiment, the button 110 includes a first inclined surface 115, and the moving member 120 includes a second inclined surface 129 abutting against the first inclined surface 115. When the button 110 is pressed down, the first inclined surface 115 of the button 110 pushes the second inclined surface 129 of the moving member 120, so that the moving member 120 moves toward a right side of FIG. 11. The button 110 and the moving member 120 may change a direction of movement through cooperation of the first inclined surface 115 and the second inclined surface 129.

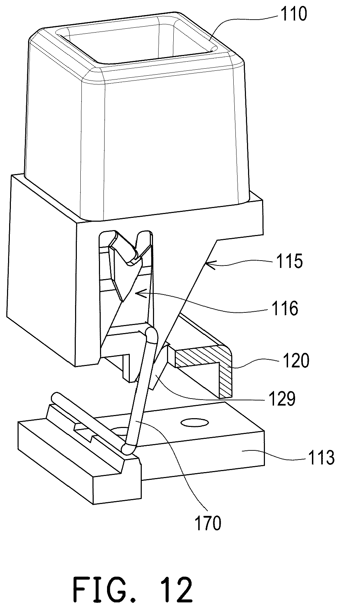

FIG. 12 is a schematic view of the button, a second elastic member, and the partial moving member of FIG. 4. Referring to FIG. 12, the button 110 in this embodiment is the push-push button 110. When the button 110 is pressed, one end of a second elastic member 170 slidably disposed on a groove structure 116 on a wall surface of the button 110, so as to stay at the button 110 in a descending position or a rising position. Another end of the second elastic member 170 abuts against a bottom wall 113 of the button base 112. Therefore, in this embodiment, the user does not need to continuously press the button 110. By pressing only once, the button 110 will stay in the descending position, so that the hook 136 remains in a disengaged state. After the user removes the expansion card assembly 40 (FIG. 1), pressing the button 110 again allows the hook 136 to return to an original position thereof, which is quite convenient in use.

Based on the above, in the remote release module of the disclosure, the moving members linked to the buttons move independently of each other, and the rotating shafts rotate independently of each other. The first driving portion of the moving member links the second driving portion of the corresponding rotating shaft. The hook is disposed beside the corresponding third driving portion. When any one of the buttons is pressed, the corresponding moving member is driven, and the first driving portion drives the second driving portion, so that the corresponding rotating shaft rotates, and then the third driving portion drives the corresponding hook to disengage. Since the linkage state of each group of the buttons, the moving members, the rotating shafts, and the hooks is independent, the user may operate as needed to enable the hook to disengage, thereby releasing the expansion card assembly at the specific position. In addition, the moving members partially overlap each other, thereby reducing an area occupied by the circuit board body.

## Claims

1. A remote release module (100), comprising:
a plurality of buttons (110);
a plurality of moving members (120) partially overlapping each other and moving independently of each other, wherein the moving members (120) respectively link the buttons (110), and respectively comprise a plurality of first driving portions (125);
a plurality of rotating shafts (130) rotating independently of each other, and respectively comprising a plurality of second driving portions (132) and a plurality of third driving portions (134) protruding from a circumferential side, wherein each of the rotating shafts (130) comprises the corresponding second driving portion (132) and the corresponding third driving portion (134), and each of the second driving portions (132) is linked to the corresponding first driving portion (125); and
a plurality of hooks (136) respectively disposed beside the third driving portions (134), wherein
when any one of the buttons (110) is pressed, the corresponding moving member (120) is driven, and the first driving portion (125) drives the second driving portion (132), so that the corresponding rotating shaft (130) rotates, and then the third driving portion (134) drives the corresponding hook (136) to disengage.

2. The remote release module (100) according to claim 1, wherein the moving members (120) respectively comprise a plurality of first segment portions (121), a plurality of second segment portions (122), a plurality of third segment portions (123), and a plurality of fourth segment portions (124) connected in sequence and in a bent manner, the buttons (110) respectively push the first segment portions (121), the first driving portions (125) are respectively located at the fourth segment portions (124), the second segment portions (122) overlap each other, and the third segment portions (123) overlap each other.

3. The remote release module (100) according to claim 1, wherein the second driving portions (132) have different protrusion lengths (H1, H2), and the first driving portions (125) respectively have different distances from the rotating shafts (130).

4. The remote release module (100) according to claim 3, wherein the rotating shafts (130) have different lengths, and the protrusion length (H1, H2) of the second driving portion (132) of one of the rotating shafts (130) having a greater length is greater than the protrusion length (H1, H2) of the second driving portion (132) of one of the rotating shafts (130) having a smaller length.

5. The remote release module (100) according to claim 1, wherein among two adjacently overlapping ones of the moving members (120), one of the moving members (120) comprises a plurality of protruding portions (126) protruding toward the other moving member (120).

6. The remote release module (100) according to claim 1, further comprising a button base (112), wherein the buttons (110) are movably disposed on the button base (112), the buttons (110) are located at a same side of the moving members (120), the button base (112) covers a portion of each of the moving members (120), the button base (112) comprises a guide post (114), the moving members (120) respectively comprise a plurality of guide slots (127) corresponding to each other, the guide post (114) penetrates through the guide slots (127).

7. The remote release module (100) according to claim 1, wherein the rotating shafts (130) extend along a same axis.

8. The remote release module (100) according to claim 1, further comprising a hook base (140), wherein the rotating shafts (130) are pivotally disposed on the hook base (140), the hooks (136) are retractably disposed on the hook base (140), the hook base (140) comprises a recessed portion (142) located between the hooks (136), and the first driving portions (125) and the second driving portions (132) are located at a same side of the recessed portion (142).

9. A circuit board device (10), comprising:
a circuit board body (20) comprising a plurality of PCI-E connectors (22);
the remote release module (100) according to any one of claims 1 to 7, wherein the hooks (136) correspond to the PCI-E connectors (22), the remote release module (100) further comprises a hook base (140), the rotating shafts (130) are pivotally disposed on the hook base (140), the hooks (136) are retractably disposed on the hook base (140), and the hook base (140) comprises a recessed portion (142) located between the hooks (136); and
a heat sink (30) spanning across the hook base (140) and extending between the PCI-E connectors (22), wherein the partial heat sink (30) is located above the recessed portion (142).

10. The circuit board device (10) according to claim 9, wherein the first driving portions (125) and the second driving portions (132) are located on a same side of the recessed portion (142), and a top surface of the heat sink (30) is flush with a top surface of the hook base (140).
